# EUROPÄISCHE PATENTSCHRIFT

(11) **EP 0 480 313 B1**
(45) Veröffentlichungstag und Bekanntmachung des Hinweises auf die Patenterteilung: **27.12.1995**
(21) Anmeldenummer: 91116902.7
(22) Anmeldetag: 04.10.1991
(51) Int. Cl.: H01L 29/812, H01L 21/28, H01L 29/41

(54) **Verfahren zur Herstellung von T-Gate-Elektroden**
Method of fabrication a T-gate-electrode
Méthode de fabrication d'une grille en forme de T

(30) Priorität: 12.10.1990 DE 4032411
(43) Veröffentlichungstag der Anmeldung: 15.04.1992
(73) Patentinhaber: Daimler-Benz Aktiengesellschaft, 70546 Stuttgart (DE)
(72) Erfinder: Dickmann, Jürgen, Dipl.-Ing., W-7900 Ulm/Einsingen (DE)
(74) Vertreter: Weber, Gerhard, Dipl.-Phys.

(56) Entgegenhaltungen:
- DE-A- 3 844 339
- DE-A- 3 933 965
- FR-A- 2 636 471
- US-A- 4 213 840
- PATENT ABSTRACTS OF JAPAN, vol. 13, no. 166 (E-746) 20. April 1989 ; & JP-A-63 318 145
- PATENT ABSTRACTS OF JAPAN, vol. 10, no. 236 (E-428) 15. August 1986 ; & JP-A-61 067 272

## Beschreibung

Die Erfindung betrifft ein Verfahren zur Herstellung von Gate-Elektroden nach dem Oberbegriff des Patentanspruchs 1.

Derartige Verfahren werden zur Herstellung von Feldeffekttransistoren, insbesondere MESFET's, MOSFET's, MODFET's, IGFET's und HIGFET's verwendet.

Aus der DE-OS 39 13 540 ist ein Verfahren zur Herstellung niederohmiger Gate-Elektroden bekannt bei dem nach der Strukturierung der auf der Bauelementoberfläche aufgebrachten Fotolackschichten, das Gate-Metall ganzflächig aufgedampft wird.

Aus der FR-A- 2 636 471 ist zur Herstellung eines Feldeffekttransistors bekannt, dessen Oberfläche mit einer ersten Fotolackschicht zu bedecken und durch reaktives Ionenätzen die Oberfläche des Gates freizulegen. Auf die Fotolackschicht und die freigelegte Oberfläche des Gates wird ganzflächig eine dicke Metallschicht und darauf eine zweite Fotolackschicht aufgebracht. In die zweite Fotolackschicht werden Fenster für die Source- und Drain-Kontakte geätzt und in den Fenstern wird durch einen weiteren Ätzprozeß die Metallschicht entfernt und dabei die zweite Fotolackschicht unterätzt. Der bei der Unterätzung verbleibende, mit der Gate-Elektrode verbundene Teil der Metallschicht bildet den späteren metallischen Gate-Kopf. Nach weiteren Ätz- und Metallisierungsschritten werden die nicht mehr benötigten Schichten entfernt.

In JP-A- 63 318 145 ist ein Herstellungsverfahren für einen Feldeffekttransistor beschrieben, bei welchem in einer auf die Oberfläche des Bauelements aufgebrachten Fotolackschicht über dem Source-Kontakt ein Fenster freigeätzt wird. Ganzflächig werden eine dünne Metallschicht und eine zweite Fotolackschicht abgeschieden.

In der zweiten Fotolackschicht wird wiederum ein Fenster freigeätzt, in welchem elektrolytisch Metall abgeschieden wird.

Der Erfindung liegt die Aufgabe zugrunde, ein gattungsgemäßes Verfahren anzugeben, mit dem Gate-Elektroden mit geringem Gate-Widerstand unter geringem technischen Aufwand herstellbar sind.

Die Aufgabe wird gelöst durch die im Patentanspruch 1 angegebenen kennzeichnenden Merkmale. Vorteilhafte Ausgestaltungen und/oder Weiterbildungen sind den Unteransprüchen zu entnehmen.

Die Erfindung hat den Vorteil, daß durch eine bereits auf der Bauelementoberfläche vorhandene Gate-Elektrode in gewünschter Höhe galvanisch verstärkt werden kann. Durch diese Verstärkung ist es möglich, eine dreieckförmige Gate-Elektrode in eine T-Gate-Elektrode mit einer größeren Querschnittsfläche umzugestalten. Die T-förmige Gate-Elektrode hat vorteilhafterweise einen geringeren Gate-Widerstand und dadurch hat der Feldeffekttransistor eine geringere Eingangszeitkonstante.

Ein weiterer Vorteil besteht darin, daß die zur Strukturierung der Gate-Elektrode notwendige Schichtenfolge, bestehend aus einer ersten Fotolackschicht, einer dünnen Metallschicht und einer zweiten Fotolackschicht problemlos durch den abschließenden Lift-off-Prozeß entfernt werden können. Durch das naßchemische Aufweichen der Fotolackschichten beim Lift-off-Prozeß wird die dazwischenliegende Metallschicht quasi gesprengt und die Schichtenfolge läßt sich leicht von der Transistoroberfläche entfernen.

Die Erfindung wird im folgenden anhand eines Ausführungsbeispiels erläutert unter bezugnahme auf schematische Zeichnungen.

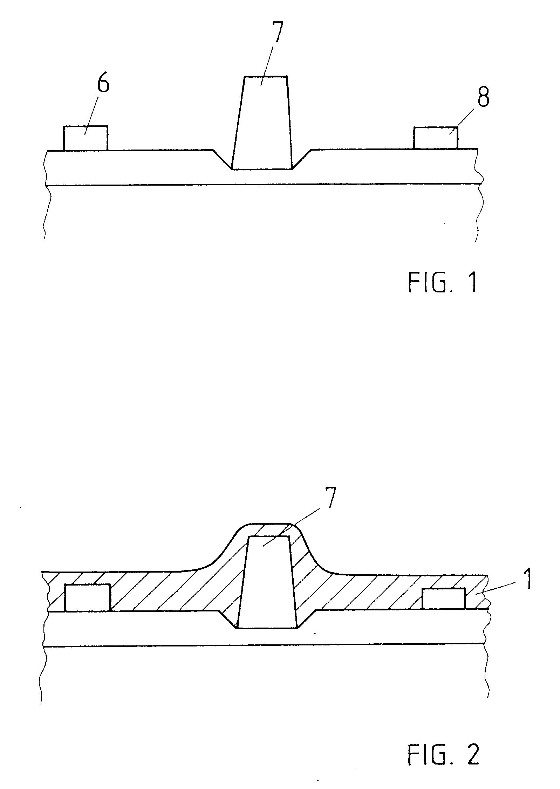

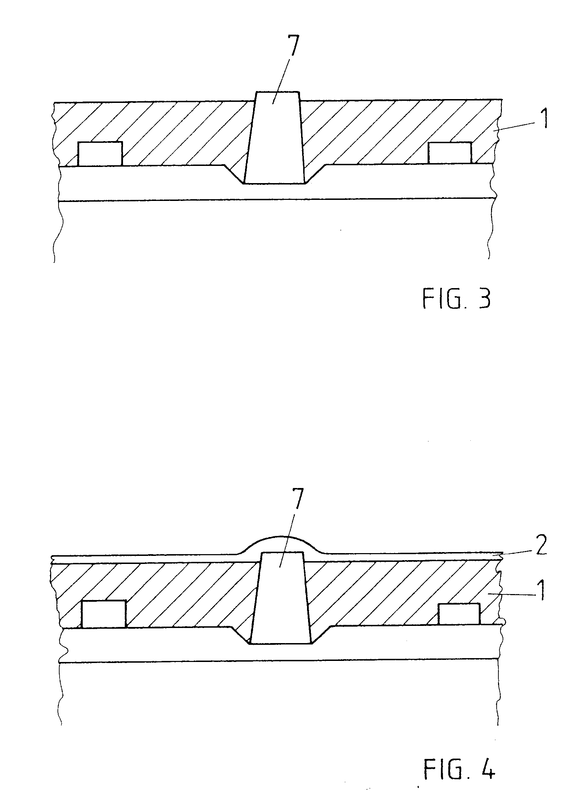

In den Figuren 1 bis 6 sind die einzelnen Vefahrensschritte zur Herstellung einer galvanisch verstärkten Gate-Elektrode dargestellt.

Der erfindungsgemäße Prozeßablauf beginnt nach dem konventionellen Herstellungsverfahren eines Feldeffekttransistors. Der Feldeffekttransistor weist beispielsweise eine annähernd dreieckförmige Gate-Elektrode 7 auf (FIG. 1), die eine Gate-Fußbreite von 0,1 bis 0,5 »m besitzt. Derartige Gate-Elektroden haben einen hohen Gate-Widerstand.

Auf die Oberfläche eines derartigen Feldeffekttransistors wird gemäß FIG. 2 eine 0,5 »m dünne erste Fotolackschicht 1, z.B. eines AZ 1350 Fotolacks, aufgeschleudert. Anschließend wird die Spitze der Gate-Elektrode mit reaktiven Ionen im O₂-Plasma freigelegt (FIG. 3). Auf die erste Fotolackschicht 1 und die Gate-Oberfläche wird eine 0,1 »m dünne Metallschicht 2 aus Gold aufgebracht (FIG. 4). Diese dünne Goldschicht wird entweder ganzflächig aufgedampft oder gesputtert. Anschließend wird eine zweite, dicke Fotolackschicht 3, z.B AZ 4330 oder AZ 4620, aufgeschleudert.

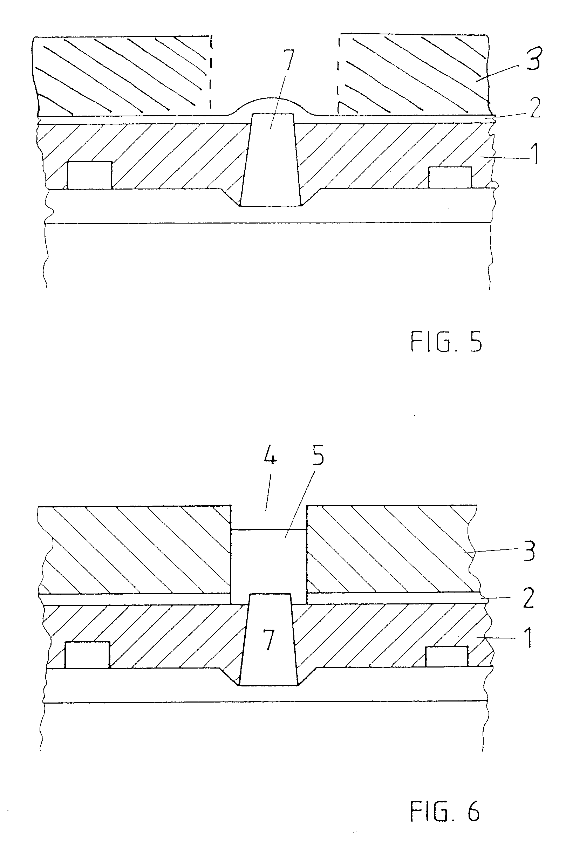

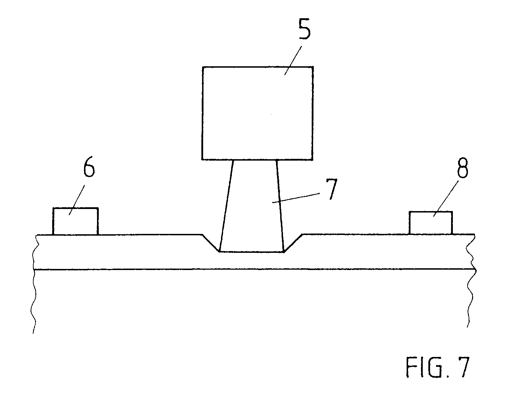

Durch geeignete Fotoprozesse wird in der zweiten Fotolackschicht 3 ein Kontaktfenster 4 mit einer Breite von ca. 1 »m geöffnet (FIG. 5). Anschließend wird durch Elektroplatieren das Gate-Metall 5, z.B. Gold, im Kontaktfenster 4 abgeschieden (FIG. 6). Die Dicke der Gate-Metallster 4 abgeschieden (FIG. 6). Die Dicke der Gate-Metallschicht beträgt je nach verwendetem Fotolack zwischen 3 »m und 6 »m. Danach werden durch einen Lift-off-Prozeß die Schichten 1, 2, 3 entfernt, so daß lediglich das Gate-Metall 5 bestehen bleibt (FIG. 7). Durch die zusätzliche Gate-Metallschicht 5 wird die Gate-Elektrode T-förmig verstärkt. Dadurch wird eine Querschnittsvergrößerung der Gate-Elektrode erzielt und der Gate-Widerstand reduziert, wodurch die maximale Grenzfrequenz des Transistors erhöht wird.

## Patentansprüche

1. Verfahren zur Herstellung einer T-Gate-Elektrode für einen Feldeffekt-Transistor, bei welchem auf die Oberfläche des einen Source-,Drain- und Gate-Anschluß aufweisenden Feldeffekttransistors eine erste dünne Fotolackschicht (1) ganzflächig aufgebracht wird, anschließend die Oberfläche der Gate-Elektrode freigelegt und eine Metallschicht und eine zweite Photolackschicht ganzflächig aufgebracht werden, dadurch gekennzeichnet,
- daß die Metallschicht als dünne Schicht abgeschieden wird,
- daß durch Foto- und Ätzprozesse die zweite Fotolackschicht derart strukturiert wird, daß ein Kontaktfenster (4) über der Gate-Elektrode (7) geöffnet wird,
- daß im Kontaktfenster (4) das Gate-Metall (5) abgeschieden wird, und
- daß anschließend die Schichten (1, 2, 3) entfernt werden.

2. Verfahren nach Anspruch 1, dadurch gekennzeichnet, daß die dünne Metallschicht (2) aufgedampft oder gesputtert wird.

3. Verfahren nach Anspruch 2, dadurch gekennzeichnet, daß Gold mit einer Schichtdicke von 0,1 »m als dünne Metallschicht (2) abgeschieden wird.

4. Verfahren nach Anspruch 1, dadurch gekennzeichnet, daß als Gate-Metall (5) Gold verwendet wird.

5. Verfahren nach Anspruch 1, dadurch gekennzeichnet, daß das Gate-Metall (5) durch Elektroplatieren im Kontaktfenster (4) abgeschieden wird.

## Claims

1. Method of manufacturing a T-gate electrode for a field effect transistor, in which a first thin photo-lacquer layer (1) is applied over the whole area on the surface of the field effect transistor, which has a source, a drain and a gate terminal, subsequently the surface of the gate electrode is exposed and a metal layer and a second photo-lacquer layer are applied over the whole area, characterised thereby
- that the metal layer is deposited as a thin layer,
- that by a photo process and an etching process the second photo-lacquer layer is structured in such a manner that a contact window (4) is opened over the gate electrode (7),
- that the gate metal (5) is deposited in the contact window (4), and
- that subsequently the layers (1, 2, 3) are removed.

2. Method according to claim 1, characterised thereby that the thin metal layer (2) is vapour deposited or applied by sputtering.

3. Method according to claim 2, characterised thereby that gold is deposited with a layer thickness of 0.1 microns as thin metal layer (2).

4. Method according to claim 1, characterised thereby that gold is used as gate metal (5).

5. Method according to claim 1, characterised thereby that the gate metal (5) is deposited by electroplating in the contact window.

## Revendications

1. Procédé pour la réalisation d'une électrode de grille en forme T pour un transistor à effet de champ, lors duquel, sur la surface du transistor à effet de champ présentant un raccordement de source, de drain et de grille, une première couche mince de laque photosensible (1) est déposée sur toute la surface, consécutivement, la surface de l'électrode de grille est libérée et une couche de métal et une deuxième couche de laque photosensible sont déposées sur toute la surface, caractérisé en ce
- que la couche de métal est déposée comme couche mince,
- que, par des photoprocessus et processus d'attaque, la deuxième couche de laque photosensible est structurée de telle sorte, qu'une fenêtre de contact (4) est ouverte sur l'électrode de grille (7),
- que dans la fenêtre de contact (4), le métal de grille (5) est déposé, et
- que, consécutivement, les couches (1, 2, 3) sont enlevées.

2. Procédé selon la revendication 1, caractérisé en ce que la mince couche de métal (2) est déposée par vaporisation ou par crépitement.

3. Procédé selon la revendication 2, caractérisé en ce que de avec une épaisseur de couche de 0,1 »m, est déposée comme couche de métal mince (2).

4. Procédé selon la revendication 1, caractérisé en ce que, comme métal de grille (5), de l'or est employé.

5. Procédé selon la revendication 1, caractérisé en ce que le métal de grille (5) est déposé par électroplacage dans la fenêtre de contact (4).
